# EUROPÄISCHE PATENTSCHRIFT

(11) **EP 1 370 387 B1**
(45) Veröffentlichungstag und Bekanntmachung des Hinweises auf die Patenterteilung: **28.07.2004**
(21) Anmeldenummer: 02730154.8
(22) Anmeldetag: 12.04.2002
(51) Int. Cl.: B23K 3/06

(54) **VORRICHTUNG ZUM AUFBRINGEN VON LOTKUGELN**
DEVICE FOR APPLYING SOLDER GLOBULES
DISPOSITIF POUR APPLIQUER DES GLOBULES DE SOUDAGE

(30) Priorität: 12.04.2001 DE 20106464 U
(43) Veröffentlichungstag der Anmeldung: 17.12.2003
(73) Patentinhaber: Pac Tech - Packaging Technologies GmbH, 14641 Nauen (DE)
(72) Erfinder: ZAKEL, Elke, 14612 Falkensee (DE); AZDASHT, Ghassem, 14052 Berlin (DE)
(74) Vertreter: Zimmermann, Tankred Klaus
(86) Internationale Anmeldenummer: PCT/EP2002/004121
(87) Internationale Veröffentlichungsnummer: WO 2002/083350

(56) Entgegenhaltungen:
- EP-A- 1 029 626
- WO-A-95/00279
- DE-U- 20 106 464
- US-A- 5 656 339

## Beschreibung

Die vorliegende Erfindung bezieht sich auf eine Vorrichtung zum Aufbringen von Lotkugeln.

Insbesondere befaßt sich die vorliegende Erfindung mit einer Vorrichtung zum Aufbringen von Lotkugeln auf ein Substrat zum Umschmelzen der Lotkugeln auf Lötstellen des Substrats.

Derartige Vorrichtungen dienen für die Herstellung von Kontaktmetallisierungen, und umfassen typischerweise eine Laserlichtquelle zum Emittieren eines Laserstrahls, ein Reservoir mit einem Vorrat an Lötmittel in fester Form, welches nachfolgend kurzerhand als Lotkugeln bezeichnet wird, eine Schutzgasquelle, eine Kapillare, mit der die Lotkugeln von dem Reservoir zu einem freien Ende der Kapillare typischerweise unter Unterstützung des unter Druck geführten Schutzgases zugeführt werden, und eine Steuerung, mit der die Vorrichtung zum Aufbringen von Lotkugeln gegenüber einem Substrat oder Substratträger bzw. einem Chip mit darüberliegendem Substratträger positioniert wird, woraufhin eine Lotkugel zum freien Ende der Kapillare zugeführt wird, wobei die Steuerung daraufhin die Laserlichtquelle veranlaßt, die positionierte Lotkugel mit einem Laserstrahl zu erwärmen und damit umzuschmelzen.

Derartige Systeme sind beispielshaft aus der US-Patentschrift 5,977,512 und aus der WO 95/00279 bekannt.

Häufig werden derartige Vorrichtungen zum Aufbringen und Umschmelzen von Lotkugeln bei der Herstellung von Kontaktmetallisierungen an flexiblen Substratmaterialien oder bei der Herstellung von Löthöckern auf Lötstellen eines flexiblen Substratträgers verwendet. Hierbei kann es zu Fehlplazierungen der Lotkugel gegenüber der gewünschten Lotstelle kommen.

Ausgehend von diesem Stand der Technik liegt der vorliegenden Erfindung die Aufgabe zugrunde, eine Vorrichtung zum Aufbringen von Lotkugeln der eingangs genannten Art so weiterzubilden, daß die Zuverlässigkeit bei der Herstellung von Lötverbindungen weiter erhöht wird.

Diese Aufgabe wird durch eine Vorrichtung gemäß Patentanspruch 1 gelöst.

Erfindungsgemäß wird bei einer Vorrichtung der eingangs genannten Art eine andere Vorrichtung am freien Ende der Kapillare angeordnet, welche zum Niederhalten des Substrats bzw. Substratträgers dient, und welche verhindert, daß das Substrat bzw. der Substratträger beim dem Plazieren der Lotkugel federt.

Bevorzugte Ausführungsbeispiele der Vorrichtung zum Aufbringen von Lotkugeln gemäß der vorliegenden Erfindung werden nachfolgend unter Bezugnahme auf die beiliegenden Zeichnungen näher erläutert. Es zeigen:
- Fig. 1: eine schematische Seitenansicht, teilweise als Querschnittsdarstellung, eines Ausführungsbeispiels der Vorrichtung zum Aufbringen von Lotkugeln; und
- Fig. 2: eine schematische Teilansicht der in Fig. 1 gezeigten Ausführungsform, um das Andrücken des Substratträgers durch die Andrückvorrichtung während des Plazierens der Lotkugel zu verdeutlichen.

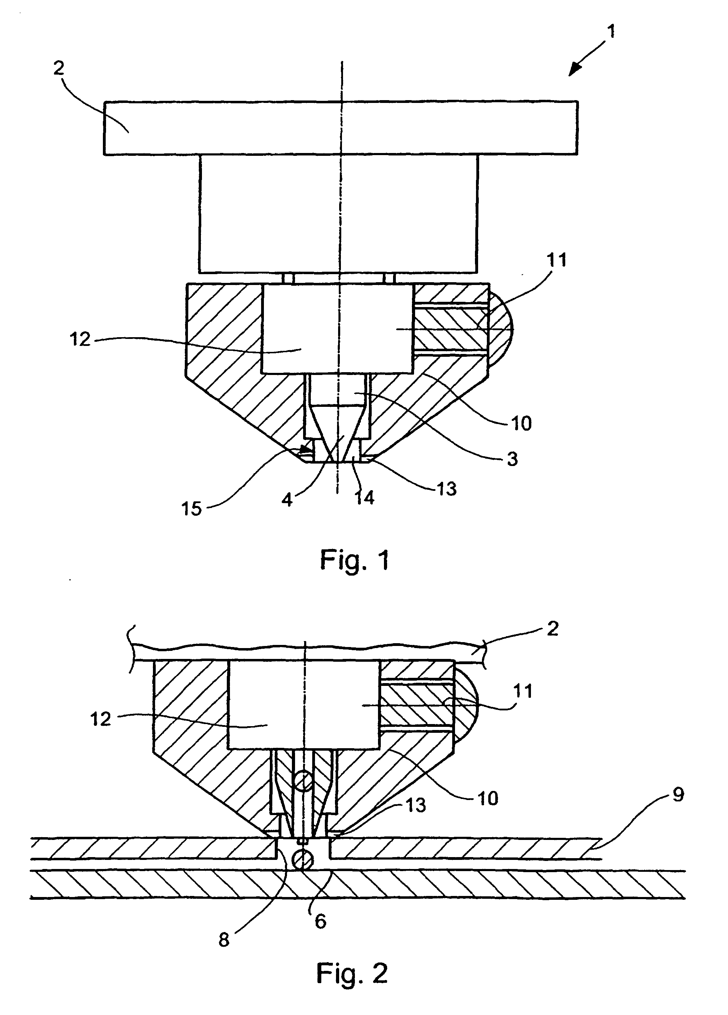

Wie in Fig. 1 gezeigt ist, umfaßt die Vorrichtung zum Aufbringen von Lotkugeln auf ein Substrat und zum Umschmelzen der Lotkugeln auf Lötstellen des Substrats, welche in ihrer Gesamtheit mit dem Bezgugszeichen 1 bezeichnet ist, einen kapillaren Halter 2, welcher zum Halten einer Kapillare 3 dient, welcher ein freies Kapillarenende 4 aufweist. Durch diese Kapillare können Lotkugeln 5, wie dies in Fig. 2 ersichtlich ist, zu einer Lötstelle 6 auf einer Substratbasis 7 zugeführt werden, welche sich im Bereich einer Öffnung 8 eines flexiblen Substrats 9 befindet. Die Vorrichtung 1 ist in dem hier gezeigten Beispielsfall mit einem kegelstumpfförmigen Niederhalter versehen, welcher über eine Klemmschraube 11 an einem Kopfteil 12 des kapillaren Halters 2 festgelegt ist, wobei dieses Kopfteil als Mutter oder Gewindeverbindung zur Befestigung des Niederhalters 10 gegenüber dem kapillaren Halter 2 ausgestaltet sein kann.

Der kegelstumpfförmige Niederhalter 10 wirkt als Andrückvorrichtung für das flexible Substrat 9 gegenüber der Substratbasis 7 im Bereich seiner Anlagefläche 13.

Die relative Lage der Anlagefläche 13 gegenüber dem freien Ende 4 der Kapillare 3 in axialer Richtung der Kapillare kann bei gelöster Klemmschraube 11 eingestellt werden und dann durch Festziehen der Klemmschraube 11 fixiert werden. Die Anlagefläche weist eine Ausnehmung 14 auf, die beim bevorzugten Ausführungsbeispiel als im Querschnitt kreisförmige Bohrung ausgeführt ist, deren Durchmesser derart bemessen ist, daß die durch diese Ausnehmung 14 festgelegte Innenkante 15 der Anlagefläche 13 radial von der Außenwand der sich verjüngenden Spitze des freien Endes 4 der Kapillare 3 beabstandet ist.

Hinsichtlich des ansonsten dem Stand der Technik entsprechenden Aufbaus der übrigen Struktur der Vorrichtung zum Aufbringen von Lotkugeln insbesondere bezüglich der Laserlichtquelle, des Reservoirs für das feste Lötmittel in Form von Lotkugeln, hinsichtlich der Schutzgasquelle und der Ansteuerung kann beispielshaft verwiesen werden auf die US-Patentschrift 5,977,512, so daß eine nochmalige Beschreibung dieser Komponenten und ihrer Funktionsweise entfallen kann.

Hinsichtlich der Funktionalität der vorliegenden Erfindung ist es für den Fachmann offenkundig, daß anstelle der erwähnten Laserlichtquelle auch andere Energiequellen zum Zuführen von Wärme zu den Lotkugeln zum Zwecke des Umschmelzens der Lotkugeln verwendet werden können. Gleichfalls ist es unmaßgeblich, ob die Wärmeübertragung zu den Lotkugeln kontaktfrei erfolgt oder ob auf die Lotkugeln eine bewegliche Energieübertragungseinrichtung aufgesetzt wird, wie dies in der WO 95/00279 beschrieben ist.

Besonders eignet sich die erfindungsgemäße Struktur der Vorrichtung zum Aufbringen von Lotkugeln mit der am freien Ende der Kapillare angeordneten Andrückvorrichtung zum Niederhalten des Substrats bei solchen Vorrichtungen, bei denen die Lotkugeln unter der Wirkung des Drucks einer Schutzgasquelle, wie beispielsweise einer Stickstoffquelle, von einer Lotkugelvereinzelungseinheit durch die Kapillare 3 an die Lötstelle 6 herangeschossen werden, um dann mittels des Laserstrahls umgeschmolzen zu werden. Durch die mechanische Festlegung des Substrats, die durch das Niederhalten des Substrats mittels der Andrückvorrichtung 10 erreicht wird, findet während des Umschmelzprozesses eine definierte Festlegung der Lotkugel gegenüber der Lötstelle 6 statt, wodurch ein zuverlässiges Umschmelzen der Lotkugel in einer definierten Lage gegenüber der Lötstelle erreicht wird.

## Patentansprüche

1. Vorrichtung zum Aufbringen von Lotkugeln auf ein Substrat (7, 9) und zum Umschmelzen der Lotkugeln auf Lötstellen (6) des Substrats (7, 9); mit
- einer Kapillare (3) zum Zuführen einer Lotkugel (5) zu der Lötstelle (6) und zum Plazieren der Lotkugel (5) am freien Ende (4) der Kapillare (3) gegenüber der Lötstelle;
- einer Einrichtung zum Zuführen von wärme zu der Lotkugel (5), um diese umzuschmelzen;
**gekennzeichnet durch**
- eine Andrückvorrichtung (10) zum Niederhalten des Substrats (7, 9), um zu verhindern, daß das Substrat (7, 9) bei dem Plazieren und Umschmelzen der Lotkugel (5) federt.

2. Vorrichtung nach Anspruch 1, bei der die Andrückvorrichtung (10) eine Anlagefläche (13) hat, die eine Ausnehmung (14) aufweist, durch die sich das freie Ende (4) der Kapillare (3) erstreckt.

3. Vorrichtung nach Anspruch 2, bei der die Ausnehmung (14) im wesentlichen kreisförmig ist und derart bemessen ist, daß eine durch diese festgelegte Innenkante (15) der Anlagefläche (13) radial von einer Außenwand der Kapillare (3) im Bereich ihres freien Endes (4) beabstandet ist.

4. Vorrichtung nach einem der Ansprüche 1 bis 3, bei der die Andrückvorrichtung (10) kegelstumpfförmig ausgestaltet ist.

5. Vorrichtung nach einem der Ansprüche 1 bis 4, bei der die Andrückvorrichtung (10) in einer vorbestimmbaren Lage in der axialen Richtung der Kapillare (3) relativ zu der Kapillare (3) festlegbar ist.

## Claims

1. An apparatus for applying solder balls to a substrate (7, 9), and for remelting the solder balls on soldering points (6) of the substrate (7, 9); with
- a capillary (3) for supplying a solder ball (5) to the soldering point (6) and for placing the solder ball (5)- at the free end (4) of a capillary (3) opposite the soldering point;
- a means for supplying heat to the solder ball (5) for remelting the same;
**characterized by**
- a pressing apparatus (10) for holding down the substrate (7, 9) to prevent the substrate (7, 9) from being resilient when placing and remelting the solder ball (5).

2. The apparatus of claim 1, wherein the pressing apparatus (10) has a fitting surface (13), which has a recess (14) through which the free end (4) of the capillary (3) extends.

3. The apparatus of claim 2, wherein the recess (14) is substantially circular and sized such that an inside edge (15) of the fitting surface (13), which is determined thereby, is radially spaced apart from an outside wall of the capillary (3) in the area of its free end (4).

4. The apparatus of one of claims 1 to 3, wherein the pressing apparatus (10) is designed in a truncated-cone-shaped manner.

5. The apparatus of one of claims 1 to 4, wherein the pressing apparatus (10) is fixable in a predeterminable location in the axial direction of the capillary (3) relative to the capillary (3).

## Revendications

1. Dispositif pour appliquer des sphères de plomb sur un substrat (7, 9) et pour faire fondre les boules de plomb aux points de brasage (6) du substrat (7, 9) ; avec
- un capillaire (3) destiné à alimenter une sphère de plomb (5) vers le point de brasage (6) et pour placer la sphère de plomb (5) à l'extrémité libre (4) du capillaire (3) vis-à-vis du point de brasage ;
- un dispositif destiné à amener de la chaleur à la sphère de plomb (5), pour faire fondre celle-ci ;
**caractérisé par**
- un dispositif de pression (10) destiné à maintenir abaissé le substrat (7, 9), afin d'éviter que le substrat (7, 9) ne fasse ressort lors du placement et de la fusion de la sphère de plomb (5).

2. Dispositif selon la revendication 1, dans lequel le dispositif de pression (10) présente une surface d'appui (13) présentant un évidement (14) à travers lequel s'étend l'extrémité libre (4) du capillaire (3).

3. Dispositif selon la revendication 2, dans lequel l'évidement (14) est sensiblement circulaire et dimensionné de sorte qu'un bord intérieur (15), fixé par ce dernier, de la surface d'appui (13) est distant radialement d'une paroi extérieure du capillaire (3) à l'endroit de son extrémité libre (4).

4. Dispositif selon l'une des revendications 1 à 3, dans lequel le dispositif de pression (10) est réalisé tronconique.

5. Dispositif selon l'une des revendications 1 à 4, dans lequel le dispositif de pression (10) peut être fixé par rapport au capillaire (3) en une position prédéterminable dans le sens axial du capillaire (3).
